# EUROPÄISCHE PATENTSCHRIFT

(11) **EP 3 612 846 B1**
(45) Veröffentlichungstag und Bekanntmachung des Hinweises auf die Patenterteilung: **03.04.2024**
(21) Anmeldenummer: 18719079.8
(22) Anmeldetag: 10.04.2018
(51) Int. Cl.: G01R 31/00, B60R 16/03, G01R 31/40, G05B 19/042

(54) **VORRICHTUNG ZUR STROMVERSORGUNG FÜR EIN STEUERGERÄT UND VERFAHREN ZUR ÜBERWACHUNG EINER STROMVERSORGUNG**
DEVICE AND POWER SUPPLY FOR A CONTROL UNIT AND METHOD FOR MONITORING A POWER SUPPLY
DISPOSITIF D'ALIMENTATION ÉLECTRIQUE POUR UN APPAREIL DE COMMANDE ET PROCÉDÉ DE SURVEILLANCE D'UNE ALIMENTATION ÉLECTRIQUE

(30) Priorität: 18.04.2017 DE 102017108207
(43) Veröffentlichungstag der Anmeldung: 26.02.2020
(73) Patentinhaber: KNORR-BREMSE Systeme für Nutzfahrzeuge GmbH, 80809 München (DE)
(72) Erfinder: FEUCHT, Thomas, 71299 Wimsheim (DE); GSCHEIDLE, Wolfgang, 71720 Oberstenfeld (DE)
(86) Internationale Anmeldenummer: PCT/EP2018/059197
(87) Internationale Veröffentlichungsnummer: WO 2018/192806

(56) Entgegenhaltungen:
- DE-A1-102006 040 753
- US-A1- 2012 161 822
- US-A1- 2013 278 272

## Beschreibung

Die Erfindung betrifft eine Vorrichtung zur Stromversorgung für ein Steuergerät, ein Steuergerät und ein Verfahren zur Überwachung einer Stromversorgung.

Fahrzeuge weisen Steuergeräte auf, die beispielsweise sicherheitsrelevante Funktionen steuern. Solche Steuergeräte benötigen eine zuverlässige Energieversorgung.

Die US 2013/278272 A1 befasst sich mit einer Vorrichtung zur Beobachtung eines hohen Spannungspotenzials an einem Spannungswandler in einem Fahrzeug. Zur Spannungswandlung kann das hohe Spannungspotenzial und das niedrige Spannungspotenzial über Schalter auf eine Zwischenleitung durchgeschaltet werden. Ein Widerstand zwischen dem hohen Spannungspotenzial und dem niedrigen Spannungspotenzial kann gemessen werden um einen Fehler zu erkennen.

Die US 2012/0161822 A1 offenbart ein Gerät zum Treiben einer elektrischen Last.

Die DE 10 2006 040 753 A1 offenbart eine redundante Stromversorgung mit Diagnosefähigkeit und Schutzbeschaltung. Die Schaltungsanordnung umfasst einen ersten Strompfad mit einem ersten Schaltelement, einen zweiten Strompfad mit einem zweiten Schaltelement und einem gemeinsamen Ausgangsanschluss des ersten und des zweiten Strompfads. In einem normalen Betriebszustand sind die Schaltelemente in einem Durchlasszustand und in einem abnormalen Betriebszustand schaltet das Schaltelement des Strompfads mit den schlechteren elektrischen Eigenschaften in einen Sperrzustand.

Der Erfindung stellt sich die Aufgabe, eine verbesserte Vorrichtung zur Stromversorgung für ein Steuergerät, ein verbessertes Steuergerät und ein verbessertes Verfahren zur Überwachung einer Stromversorgung zu schaffen.

Erfindungsgemäß wird diese Aufgabe durch eine Vorrichtung zur Stromversorgung für ein Steuergerät, ein Steuergerät und ein Verfahren zur Überwachung einer Stromversorgung mit den Merkmalen der Hauptansprüche gelöst. Vorteilhafte Ausgestaltungen und Weiterbildungen der Erfindung ergeben sich aus den nachfolgenden Unteransprüchen.

Eine Vorrichtung zur Stromversorgung für ein Steuergerät für ein Fahrzeug weist die Merkmale des Anspruchs 1 auf.

Bei dem Fahrzeug kann es sich beispielsweise um ein Fahrzeug zur Personenbeförderung oder zur Beförderung von Gütern handeln. Beispielsweise kann das Fahrzeug ein Kraftfahrzeug, ein Elektrofahrzeug oder ein Schienenfahrzeug sein. Bei dem Steuergerät kann es sich um ein elektrisches Gerät handeln, das beispielsweise über eine Schnittstelle Sensorsignale einlesen und unter Verwendung der Sensorsignale Steuersignale zum Steuern einer Funktion des Fahrzeugs über eine Schnittstelle ausgeben kann. Die beiden Stromversorgungspfade stellen redundante Stromversorgungspfade dar. Somit kann eine zum Betrieb des Steuergeräts erforderliche Versorgungsspannung sowohl an dem ersten Anschluss als auch an dem zweiten Anschluss anliegen oder ein zum Betrieb des Steuergeräts erforderlicher Versorgungsstrom kann sowohl über den ersten Anschluss als auch über den zweiten Anschluss fließen. Ein Schalter ermöglicht in einem geschlossenen Zustand einen Stromfluss zwischen den Kontakten des Schalters und unterbindet einen Stromfluss in einem geöffneten Zustand . Bei einem Messwert kann es sich um einen Spannungswert handeln. Der Spannungswert kann einem Spannungspotenzial des entsprechenden Stromversorgungspfads entsprechen oder von dem Spannungspotenzial abhängig sein. In dem Testzustand der Vorrichtung können die Stromversorgungspfade oder zumindest einer der Stromversorgungspfade überprüft werden, beispielsweise hinsichtlich des Vorliegens einer beispielsweise durch einen Kurzschluss hervorgerufenen Störung. Zum Ansteuern der Schalter kann die Steuereinrichtung ausgebildet sein, um zumindest ein Steuersignal an eine Schnittstelle zu den Schaltern bereitzustellen. Die Überwachungseinrichtung kann ausgebildet sein, um die Messwerte auszuwerten, um das Vorliegen einer Störung an zumindest einem der Stromversorgungspfade erkennen zu können. Dazu können die Messwerte miteinander kombiniert werden. Das Überwachungssignal kann ausgebildet sein, um einen störungsfreien Zustand oder eine Störung an zumindest einem der Stromversorgungspfade anzuzeigen. Der Testzustand kann von der Vorrichtung beispielsweise vor einer Inbetriebnahme oder kurzzeitig während eines Betriebs der Vorrichtung eingenommen werden.

Die Vorrichtung kann eine Diode (z.B. Body-Diode eines FETs) aufweisen, die parallel zum ersten Schalter zwischen den ersten Anschluss und den Sternpunkt geschaltet ist. Entsprechend kann die Vorrichtung eine weitere Diode (z.B. Body-Diode eines FETs) aufweisen, die parallel zum zweiten Schalter zwischen den zweiten Anschluss und den Sternpunkt geschaltet ist. Die Dioden ermöglichen einen Stromfluss zwischen dem Sternpunkt und dem jeweiligen Anschluss auch dann, wenn der jeweilige Schalter geöffnet ist. Die Diode kann als diskretes Element ausgeformt sein oder als Teil einer die Diode und den jeweiligen Schalter umfassenden Schaltungseinrichtung ausgeformt sein.

Die Steuereinrichtung kann ausgebildet sein, um die Schalter ansprechend auf eine Inbetriebnahme der Vorrichtung zu schließen. Auf diese Weise wird der Widerstand zwischen dem Sternpunkt und den Anschlüssen minimiert. Bei einer Außerbetriebnahme der Vorrichtung kann die Steuereinrichtung ausgebildet sein, um die Schalter zu öffnen.

Die Steuereinrichtung kann ausgebildet sein, um während einer ersten Phase des Testzustands den ersten Schalter geöffnet und den zweiten Schalter geschlossen zu halten. Während einer zweiten Phase des Testzustands kann die Steuereinrichtung ausgebildet sein, um den ersten Schalter geschlossen und den zweiten Schalter geöffnet zu halten. Die erste Phase und die zweite Phase können in beliebiger Reihenfolge zeitlich direkt aufeinanderfolgen oder zeitlich zueinander beabstandet sein. Indem abwechselnd der erste und der zweite Schalter geöffnet werden, während der jeweils andere Schalter geschlossen ist, können die Stromversorgungspfade abwechselnd überprüft werden.

Der Sternpunkt repräsentiert einen Masseanschluss für eine elektrische Schaltung des Steuergeräts. Somit handelt es sich bei den Stromversorgungspfaden um Masse-Stromversorgungspfade, sogenannte GND-Stromversorgungspfade oder kurz GND-Pfade.

Die Überwachungseinrichtung kann ausgebildet sein, um den ersten Messwert und den zweiten Messwert miteinander zu vergleichen, um eine Abweichung zwischen den Spannungspotenzialen der Stromversorgungspfade zu ermitteln. Dabei kann das Überwachungssignal die Abweichung anzeigen. Durch einen Vergleich kann auf einfache Weise festgestellt werden, das einer der Stromversorgungspfade nicht das vorgesehene Spannungspotenzial aufweist.

Gemäß einer Ausführungsform kann der erste Messkontakt auf einer ersten Verbindungsleitung zwischen dem ersten Anschluss und dem ersten Kontakt des ersten Schalters angeordnet sein. Entsprechend kann der zweite Messkontakt auf einer zweiten Verbindungsleitung zwischen dem zweiten Anschluss und dem ersten Kontakt des zweiten Schalters angeordnet sein. Dies ermöglicht eine sehr einfache Realisierung.

Die Vorrichtung weist einen dritten Anschluss zum Bereitstellen eines Spannungspotenzials auf. Ferner weist die Vorrichtung eine zumindest einen ersten Widerstand und eine erste Diode umfassende erste Stichleitung, die den dritten Anschluss mit dem ersten Anschluss verbindet, und eine zumindest einen zweiten Widerstand und eine zweite Diode umfassende zweite Stichleitung auf, die den dritten Anschluss mit dem zweiten Anschluss verbindet. In diesem Fall ist der erste Messkontakt auf der ersten Stichleitung und der zweite Messkontakt auf der zweiten Stichleitung angeordnet.

Die Widerstände ermöglichen die Erfassung einer Spannungsdifferenz zwischen dem ersten und dem dritten Anschluss sowie zwischen dem zweiten und dem dritten Anschluss. Sind die Stromversorgungspfade ungestört, so sollten die Spannungsdifferenzen gleich sein, sofern die Widerstände und Ströme in den einzelnen Pfaden gleich groß sind.

Ein Steuergerät für ein Fahrzeug kann eine genannte Vorrichtung zur Stromversorgung des Steuergeräts umfassen. Die Vorrichtung kann dabei in das Steuergerät integriert sein, beispielsweise innerhalb eines das Steuergerät umschließenden Gehäuses angeordnet sein. Vorteilhafterweise kann unter Verwendung der Vorrichtung erkannt und angezeigt werden, wenn eine Störung in der Energieversorgung des Steuergeräts vorliegt.

Ein Verfahren zur Überwachung einer Stromversorgung für ein Steuergerät ist im Anspruch 7 definiert.

Ausführungsbeispiele des hier vorgestellten Ansatzes sind in den Zeichnungen dargestellt und in der nachfolgenden Beschreibung näher erläutert. Es zeigt:
Fig. 1 eine schematische Darstellung eines Fahrzeugs mit einem Steuergerät mit einer Vorrichtung zur Stromversorgung gemäß einem Ausführungsbeispiel;
Fig. 2 ein Schaltbild eines Steuergeräts mit einer Vorrichtung zur Stromversorgung gemäß einem Ausführungsbeispiel;
Fig. 3 ein Schaltbild einer Vorrichtung zur Stromversorgung gemäß einem Ausführungsbeispiel;
Fig. 4 ein Schaltbild einer Vorrichtung zur Stromversorgung gemäß einem Ausführungsbeispiel; und
Fig. 5 ein Ablaufdiagramm eines Verfahrens zur Stromversorgung gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

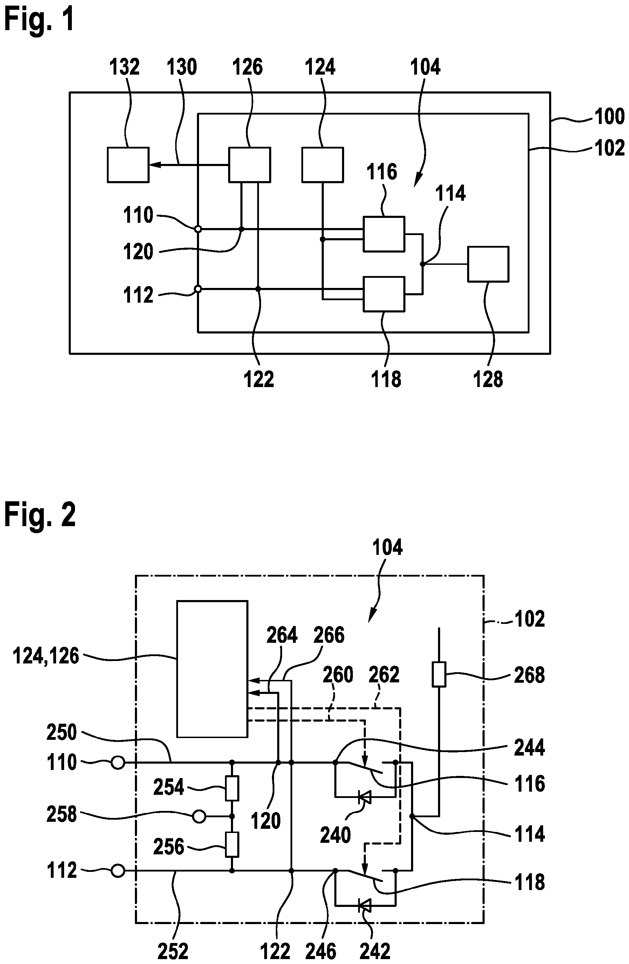

Fig. 1 zeigt eine schematische Darstellung eines Fahrzeugs 100 mit einem Steuergerät 102 mit einer Vorrichtung 104 zur Stromversorgung gemäß einem Ausführungsbeispiel. Beispielsweise kann das Steuergerät 102 zum Bereitstellen einer für eine Fahrassistenzfunktion oder für eine zum Betrieb des Fahrzeugs 100 erforderliche Funktion verwendet werden.

Die Vorrichtung 104 umfasst einen ersten Anschluss 110 für einen ersten Stromversorgungspfad, einen zweiten Anschluss 112 für einen zweiten Stromversorgungspfad und einen Sternpunkt 114 zum Verbinden des ersten Stromversorgungspfads und des zweiten Stromversorgungspfads. Die Anschlüsse 110, 112 sind gemäß diesem Ausführungsbeispiel als Schnittstellen zum elektrischen Kontaktieren des Steuergeräts 102 ausgeführt. Der Sternpunkt 114 ist innerhalb des Steuergeräts 102 angeordnet.

Die Vorrichtung 104 umfasst ferner einen ersten Schalter 116, der zwischen den ersten Anschluss 110 und den Sternpunkt 114 geschaltet ist, sowie einen zweiten Schalter 118 der zwischen den zweiten Anschluss 112 und den Sternpunkt 114 geschaltet ist.

Ein erster Messkontakt 120 ist hier beispielhaft auf einer den ersten Anschluss 110 mit dem ersten Schalter 116 verbindenden Leitung angeordnet und ein zweiter Messkontakt 122 ist beispielhaft auf einer den zweiten Anschluss 112 mit dem zweiten Schalter 118 verbindenden Leitung angeordnet.

Die Vorrichtung 104 umfasst ferner eine Steuereinrichtung 124 und eine Überwachungseinrichtung 126. Die Steuereinrichtungen 124 und die Überwachungseinrichtung 126 können als separate Einheiten ausgeführt sein, in einer Einheit zusammengefasst sein, oder beispielsweise in eine Schaltung 128 zur Bereitstellung der Funktion des Steuergeräts 102 integriert sein.

Die Vorrichtung 104 kann einen Testzustand einnehmen, in dem die Stromversorgungspfade überprüft werden. Ansprechend auf oder während des Testzustands ist die Steuereinrichtung 124 ausgebildet, um einen der Schalter 116, 118 geöffnet und den anderen der Schalter 116, 118 geschlossen zu halten.

Die Überwachungseinrichtung 126 ist ausgebildet, um über den ersten Messkontakt 120 einen ersten Messwert und über den zweiten Messkontakt 122 einen zweiten Messwert einzulesen und unter Verwendung des ersten Messwertes und des zweiten Messwertes ein Überwachungssignal 130 bereitzustellen. Das Überwachungssignal 130 zeigt gemäß einem Ausführungsbeispiel an, dass eine Störung auf einem der Stromversorgungspfade vorliegt, wenn eine Abweichung zwischen den Messwerten erkannt wird. Das Überwachungssignal 130 wird gemäß einem Ausführungsbeispiel an eine Warneinrichtung 132 des Fahrzeugs 100 bereitgestellt.

Gemäß einem Ausführungsbeispiel wird das an dem Sternpunkt 114 anliegende Spannungspotenzial zum Betrieb der Schaltung 128 verwendet.

Fig. 2 zeigt ein Schaltbild eines Steuergeräts 102 mit einer Vorrichtung 104 zur Stromversorgung gemäß einem Ausführungsbeispiel. Dabei kann es sich um ein Ausführungsbeispiel des anhand von Fig. 1 beschriebenen Steuergeräts 102 handeln.

Neben den bereits anhand von Fig. 1 beschriebenen Merkmalen umfasst die Vorrichtung 104 gemäß diesem Ausführungsbeispiel eine Diode 240, die parallel zu dem ersten Schalter 116 geschaltet ist und eine weitere Diode 242, die parallel zu dem zweiten Schalter 118 geschaltet ist. Die Anoden der Dioden 240, 242 sind gemäß diesem Ausführungsbeispiel mit dem Sternpunkt 114 verbunden.

Der erste Messkontakt 120 ist auf einer den ersten Anschluss 110 mit einem ersten Kontakt 244 des ersten Schalters 116 verbindenden Leitung 250 angeordnet und der zweite Messkontakt 122 ist auf einer den zweiten Anschluss 112 mit einem ersten Kontakt 246 des zweiten Schalters 118 verbindenden Leitung 252 angeordnet. Die Leitungen 250, 252 sind gemäß diesem Ausführungsbeispiel über eine Serienschaltung aus zwei Widerständen 254, 256 verbunden. Ein dritter Anschluss 258 ist mit einer die Widerstände 254, 256 verbindenden Leitung gekoppelt.

Gemäß einem Ausführungsbeispiel liegt an dem ersten Anschluss 110 ein Spannungspotenzial GND 1, an dem zweiten Anschluss 112 ein Spannungspotenzial GND 2 und an dem dritten Anschluss 258 ein Spannungspotenzial VDD an. Im störungsfreien Betrieb des Steuergeräts 102 sind die Spannungspotenziale GND 1, GND 2 gleich groß und unterscheiden sich von dem Spannungspotenzial VDD. Somit dienen die Widerstände 254, 256 als Pull-up- bzw. Pull-down-Widerstände.

Die Steuereinrichtung 124 und die Überwachungseinrichtung 126 sind gemäß diesem Ausführungsbeispiel in einem Mikrocontroller zusammengefasst.

Die Steuereinrichtung 124 ist ausgebildet, um ein erstes Steuersignal 260 an einen Steuereingang des ersten Schalters 116 und ein zweites Steuersignal 262 an einen Steuereingang des zweiten Schalters 118 bereitzustellen. In dem gezeigten Zustand der Vorrichtung 104 sind die Steuersignale 260, 262 geeignet, beispielsweise aufgrund ihres aktuellen Signalpegels, um die Schalter 116, 118 in einer geöffneten Position zu halten.

Die Überwachungseinrichtung 126 ist ausgebildet, um über den ersten Messkontakt 120 einen ersten Messwert 264 und über den zweiten Messkontakt 122 einen zweiten Messwert 266 einzulesen. Der erste Messwert 264 bildet ein an der ersten Leitung 250 anliegendes Spannungspotenzial und der zweite Messwert 266 ein an der zweiten Leitung 252 anliegendes Spannungspotenzial ab.

Der Sternpunkt 114 ist gemäß diesem Ausführungsbeispiel mit einem Widerstand 268 verbunden, der auch als Widerstand RL bezeichnet wird.

Gemäß einem Ausführungsbeispiel wird der hier beschriebene Ansatz für einen Verpolschutz für eine redundante Stromversorgung in sicherheitskritischen Systemen eingesetzt.

In der Automobiltechnik, insbesondere bei sicherheitskritischen Systemen wie ABS/EBS/ESP/Getriebestellern, wird vermehrt auf eine stabile und sichere Stromversorgung Wert gelegt, um diese Systeme möglichst permanent verfügbar zu haben. Aus diesem Grund besteht bei diesen Systemen die Forderung nach einer redundanten Stromversorgung. Die Geräte, beispielsweise entsprechend dem gezeigten Steuergerät 102, verfügen dabei für die Batteriespannung (UB) und die Masse (GND) jeweils über zwei vollkommen getrennte und autark geführte Zuleitungen, die über die Anschlüsse 110, 112 an das Steuergerät 102, auch als ECU bezeichnet, geführt werden. Dort können diese beiden redundanten Leitungen an dem Sternpunkt 114 z.B. wieder zu einer gemeinsamen Versorgung zusammen geführt werden.

Um die Funktion der redundanten Stromversorgung sicherstellen zu können, ist eine besondere Überwachung der einzelnen Zuleitungen notwendig. Fehler in den Zuleitungen, Steckverbindungen, Sicherungen, etc. sollen sicher erkannt und angezeigt werden können, beispielsweise über das Überwachungssignal 130. Im Fehlerfall kann dann z.B. ein Stromversorgungspfad abgeschaltet werden, um eine dauerhafte Durchleitung eines Stromes durch das Steuergerät 102 zu verhindern. Die Stromversorgung ist in diesem Fall über den verbleibenden intakten Stromversorgungspfad noch voll funktionsfähig. Somit lässt sich ein quasi-redundantes System mit zwei getrennten Zuleitungen realisieren, die in dem Steuergerät 102 zusammengeführt werden.

Dazu sind zwei redundante Stromversorgungspfade, hier GND-Stromversorgungspfade vorhanden, deren Zustand diagnostizierbar ist. Im Fehlerfall, bei dem ein Stromversorgungspfad defekt ist, ist über den anderen noch intakten Stromversorgungspfad die Stromversorgung des gesamten Gerätes 102 möglich.

Gemäß dem beschriebenen Ansatz sind prinzipiell zwei unabhängige Stromversorgungspfade vorhanden. Während des voll funktionsfähigen Normalbetriebs sind beide Stromversorgungspfad parallel zugeschaltet, sodass sich die gesamte Stromaufnahme des Systems auf diese beiden Stromversorgungspfaden idealerweise gleichmäßig aufteilt.

Durch zyklische wechselweise Testpulse an beiden Stromversorgungspfaden kann die Qualität eines Stromversorgungspfads erkannt werden. Im Fehlerfall kann der Fahrer des Fahrzeugs gewarnt werden, beispielsweise unter Verwendung der Warneinrichtung 132, und das System kann in den sicheren Abschaltzustand gebracht werden. Die beiden redundanten Stromversorgungspfade weisen schaltbare Dioden 240, 242 und eine positive/negative Spannungsmessung unter Verwendung der Messwerte 264, 266 auf.

Der beschriebene Ansatz weist gemäß unterschiedlicher Ausführungsbeispiele eine Vielzahl von Vorteilen auf. So sind gemäß einem Ausführungsbeispiel zwei unabhängige Stromversorgungspfade (Redundanz) für den negativen (GND-)Zweig vorgesehen. Es werden prüfbare und schaltbare Verpolschutz-Dioden eingesetzt. Eine Erkennung einer Unterbrechung von einem GND- Stromversorgungspfad ist gegeben. Ferner ist eine Erkennung von Kurzschluss gegen die Batteriespannung und ein Abschalten dieses Stromversorgungspfads möglich, um eine dauerhafte Durchleitung von hohen Strömen durch das Steuergerät 102 zu verhindern. Eine Erkennung eines Kurzschlusses zwischen internem und externem Massepotenzial GND ist möglich. Ferner ist ein Entfall von sonst notwendigen Verpolschutz-Dioden an Leistungsschutzschaltern gegeben. Das Steuergerät 102 bleibt durch die Trennung des defekten GND-Einganges in Form eines der Anschlüsse 110, 112 vom internen Massepotenzial, das an dem Sternpunkt 114 anliegt, noch diagnosefähig und kann den Fehlerzustand an andere weitere Systeme im Fahrzeug kommunizieren. Dadurch ist die funktionale Sicherheit gewährleistet.

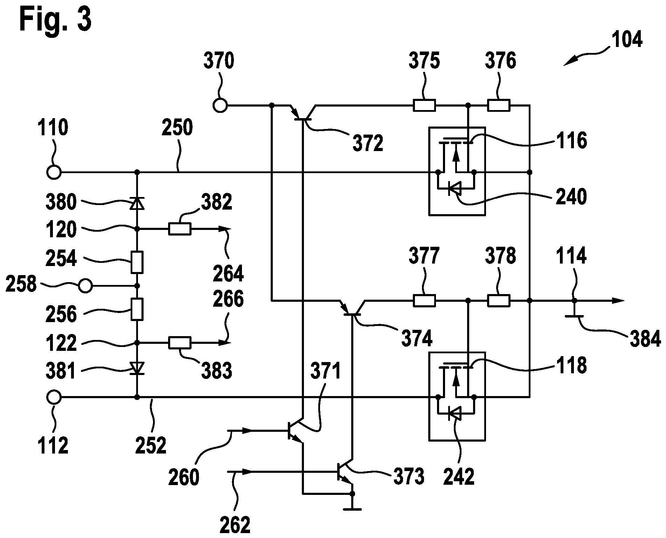

Fig. 3 zeigt ein Schaltbild einer Vorrichtung 104 zur Stromversorgung gemäß einem Ausführungsbeispiel. Dabei kann es sich um ein Ausführungsbeispiel der anhand von Fig. 2 beschriebenen Vorrichtung handeln.

Gemäß diesem Ausführungsbeispiel sind der erste Schalter 116 und die Diode 240 durch eine erste Transistoreinrichtung und der zweite Schalter 118 und die weitere Diode 242 durch eine zweite Transistoreinrichtung realisiert.

Zum Ansteuern der Schalter 116, 118 umfasst die Vorrichtung 104 gemäß diesem Ausführungsbeispiel einen vierten Anschluss 370, einen ersten Transistor 371, einen zweiten Transistor 372, einen dritten Transistor 373, einen vierten Transistor 374, einen dritten Widerstand 375, einen vierten Widerstand 376, einen fünften Widerstand 377 und einen sechster Widerstand 378. An dem vierten Anschluss 370 liegt im Betrieb der Vorrichtung 104 ein Spannungspotenzial VDD10 an, das sich beispielhaft von dem an dem dritten Anschluss 258 anliegenden Spannungspotenzial, hier beispielsweise VDD5, unterscheidet.

Das erste Steuersignal 260 wird an einen Steuereingang des ersten Transistors 371 bereitgestellt, der zwischen einen Steuereingang des zweiten Transistors 372 und einem Masseanschluss geschaltet ist. Der zweite Transistor 372 ist zwischen den vierten Anschluss und einen ersten Kontakt des dritten Widerstands 375 geschaltet. Ein zweiter Kontakt des dritten Widerstands 375 ist mit einem Steueranschluss des ersten Schalters 116 und einem ersten Kontakt des vierten Widerstands 376 verbunden. Ein zweiter Kontakt des vierten Widerstands 376 ist mit dem Sternpunkt 114 verbunden.

Das zweite Steuersignal 262 wird an einen Steuereingang des dritten Transistors 373 bereitgestellt, der zwischen einen Steuereingang des vierten Transistors 374 und den Masseanschluss geschaltet ist. Der dritte Transistor 373 ist zwischen den vierten Anschluss und einen ersten Kontakt des fünften Widerstands 377 geschaltet. Ein zweiter Kontakt des fünften Widerstands 377 ist mit einem Steueranschluss des zweiten Schalters 118 und einem ersten Kontakt des sechsten Widerstands 378 verbunden. Ein zweiter Kontakt des sechsten Widerstands 378 ist mit dem Sternpunkt 114 verbunden.

Der dritte Anschluss 258 ist gemäß diesem Ausführungsbeispiel über den ersten Widerstand 254 und eine erste Diode 380 mit der ersten Leitung 250 verbunden. Entsprechend ist der dritte Anschluss 258 gemäß diesem Ausführungsbeispiel über den zweiten Widerstand 256 und eine zweite Diode 382 mit der zweiten Leitung 252 verbunden.

Der erste Messwert 264 wird gemäß diesem Ausführungsbeispiel über einen siebten Widerstand 382 von dem ersten Messpunkt 120 eingelesen, der auf einer den ersten Widerstand 254 und die erste Diode 380 verbindenden Verbindungsleitung angeordnet ist. Der zweite Messwert 266 wird entsprechend über einen achten Widerstand 383 von dem zweiten Messpunkt 122 eingelesen, der auf einer den zweiten Widerstand 256 und die zweite Diode 382 verbindenden Verbindungsleitung angeordnet ist.

Gemäß einem Ausführungsbeispiel sind im nicht aktivierten Zustand der die Vorrichtung 104 realisierenden Schaltung die beiden Schalter 116, 118, auch als Hauptschalter oder GND-Schalter bezeichnet, nicht zugeschaltet. Die beiden Schalter 116, 118 sind durch deren integrierte Diode 240, 242, die hier als Bodydiode bei vorzugsweiser Verwendung von MOSFETs für die Schalter 116, 118 realisiert ist, auch im abgeschalteten Zustand der Schalter 116, 118 leitend.

Das an dem Sternpunkt 114 anliegende interne Massepotenzial 384, auch als internes GND bezeichnet, ist bei korrekter Polung immer durchgeschaltet, unabhängig davon, ob die Schalter 116, 118 tatsächlich aktiviert sind oder nicht.

Sobald bei korrekter Polung die Stromversorgung zugeschaltet wird, werden die beiden Schalter 116, 118 nach Überprüfung von den an den Anschlüssen 110, 112 anliegenden Potenzialen GND1, GND2 zugeschaltet. Dadurch wird sichergestellt, dass zwischen dem an dem Sternpunkt 114 anliegenden internen Massepotenzial 384 und den beiden Anschlüssen 110, 112 nur noch ein vernachlässigbarer Potenzialversatz durch die beiden Dioden 240, 242 vorhanden ist. Dadurch ergibt sich ein minimaler Spannungsabfall und eine minimale Verlustleistung an den Schaltern 116, 118 und an der jeweiligen Diode 240, 242.

Der Mikrocontroller mit den Einrichtungen 124, 126 kann für Testzwecke die beiden Schalter 116, 118 einzeln zu- und abschalten. Wird einer der Schalter 116, 118 abgeschaltet und ist an einem der beiden Eingangspfade an den Anschlüssen 110, 112 eine nennenswerte Potenzialdifferenz untereinander vorhanden, sind also die an den Anschlüssen 110, 112 anliegenden Spannungen unterschiedlich (z.B. durch einen Masseversatz), ergibt sich an den Pull-up-Widerständen 254, 256 und den auch als Rückspeiseschutzdioden bezeichneten Dioden 380, 381 eine Spannungsdifferenz, die über die beiden auch als Rückmeldeeingänge bezeichneten Messpunkte 120, 122 vom Mikrocontroller erkannt werden kann. Ein eventuell vorhandener Fehler kann so dem Fahrer angezeigt werden.

Die Rückmeldung der beiden an den Anschlüssen 110, 112 anliegenden GNDs kann auch in der Weise ausgeführt werden, dass sowohl negative, als auch positive Spannungen an den Anschlüssen 110, 112 gemessen werden können. Damit ist eine Erkennung auf Kurzschluss gegen die Batteriespannung, eine Unterbrechung und ein Kurzschluss zwischen internem Massepotenzial 384 und externen an den Anschlüssen 110, 112 anliegenden Massepotenzialen möglich.

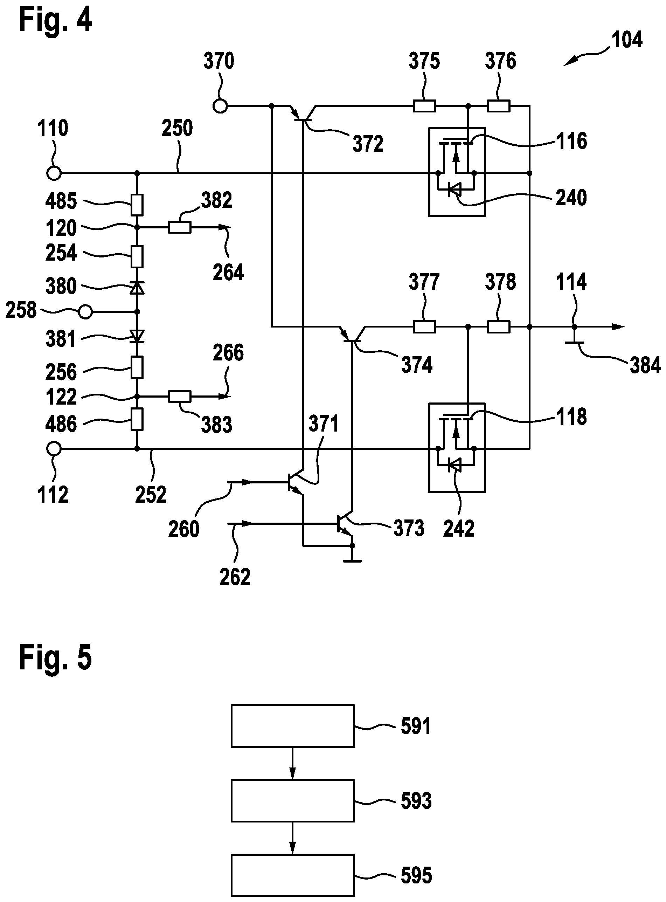

Fig. 4 zeigt ein Schaltbild einer Vorrichtung 104 zur Stromversorgung gemäß einem Ausführungsbeispiel. Dabei kann es sich um ein Ausführungsbeispiel der anhand von Fig. 2 beschriebenen Vorrichtung handeln. Die in Fig. 4 gezeigte Vorrichtung 104 entspricht der anhand von Fig. 3 gezeigten Vorrichtung, mit dem Unterschied, das der dritte Anschluss 258 und die Messpunkte 120, 122 anders verschaltet sind.

Gemäß diesem Ausführungsbeispiel ist der dritte Anschluss 258 über die erste Diode 380, den ersten Widerstand 254 und einen neunten Widerstand 485 mit der ersten Leitung 250 verbunden. Der erste Messwert 264 über den siebten Widerstand 382 von dem ersten Messpunkt 120 eingelesen, der auf einer den ersten Widerstand 254 und den neunten Widerstand 485 verbindenden Leitung angeordnet ist.

Entsprechend ist der dritte Anschluss 258 über die zweite Diode 381, den zweiten Widerstand 256 und einen zehnten Widerstand 486 mit der zweiten Leitung 252 verbunden. Der zweite Messwert 266 wird über den achten Widerstand 383 von dem zweiten Messpunkt 122 eingelesen, der auf einer den zweiten Widerstand 256 und den zehnten Widerstand 486 verbindenden Leitung angeordnet ist.

Fig. 5 zeigt ein Ablaufdiagramm eines Verfahrens zur Stromversorgung gemäß einem Ausführungsbeispiel. Das Verfahren kann beispielsweise im Zusammenhang mit einer anhand der vorangegangenen Figuren beschriebenen Vorrichtung zur Stromversorgung ausgeführt werden.

In einem Schritt 591 wird zumindest ein Steuersignal an eine Schnittstelle zu den Schaltern bereitgestellt, um einen der Schalter geöffnet und den anderen der Schalter geschlossen zu halten. In einem Schritt 593 wird ein erster Messwert und ein zweiter Messwert eingelesen. In einem Schritt 595 wird ein Überwachungssignal unter Verwendung der Messwerte bereitgestellt.

Der Schritt 591 kann beispielsweise von der im vorangegangenen beschriebenen Steuereinrichtung und die Schritte 593, 595 können von der im vorangegangenen beschriebenen Überwachungseinrichtung ausgeführt werden.

Die Schritte 591, 593, 595 können wiederholt ausgeführt werden, wobei im Schritt 591 das zumindest eine Steuersignal alternierend so bereitgestellt wird, dass abwechselnd in einer ersten Phase der erste Schalter geschlossen und der zweite Schalter geöffnet sowie in einer zweiten Phase der erste Schalter geöffnet und der zweite Schalter geschlossen ist.

Die Schritte 591, 593, 595 können während eines Testzustands der Vorrichtung ausgeführt werden. Bei einer Inbetriebnahme der Vorrichtung kann der Schritt 591 für sich alleine ausgeführt werden, wobei das zumindest eine Steuersignal so bereitgestellt wird, dass beide Schalter geschlossen werden. Bei einer Außerbetriebnahme der Vorrichtung kann der Schritt 591 für sich alleine ausgeführt werden, wobei das zumindest eine Steuersignal so bereitgestellt wird, dass beide Schalter geöffnet werden.

Der Testzustand wird gemäß einem Ausführungsbeispiel nach der Inbetriebnahme der Vorrichtung mehrfach wiederholt ausgeführt, beispielsweise in vorgegebenen Zeitabständen.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### BEZUGSZEICHENLISTE

- 100: Fahrzeug
- 102: Steuergerät
- 104: Vorrichtung
- 110: erster Anschluss
- 112: zweiter Anschluss
- 114: Sternpunkt
- 116: erster Schalter
- 118: zweiter Schalter
- 120: erster Messpunkt
- 122: zweiter Messpunkt
- 124: Steuereinrichtung
- 126: Überwachungseinrichtung
- 128: Schaltung
- 130: Überwachungssignal
- 132: Warneinrichtung
- 240: Diode (Bodydiode)
- 242: weitere Diode (Bodydiode)
- 244: erster Kontakt des ersten Schalters
- 246: erster Kontakt des zweiten Schalters
- 250: erste Leitung
- 252: zweite Leitung
- 254: erster Widerstand
- 256: zweiter Widerstand
- 258: dritter Anschluss
- 260: erstes Steuersignal
- 262: zweites Steuersignal
- 264: erster Messwert
- 266: zweiter Messwert
- 268: Widerstand
- 370: vierter Anschluss
- 371: Transistor
- 372: Transistor
- 373: Transistor
- 374: Transistor
- 375: Widerstand
- 376: Widerstand
- 377: Widerstand
- 378: Widerstand
- 380: erste Diode
- 381: zweite Diode
- 382: Widerstand
- 383: Widerstand
- 384: internes Massepotenzial
- 485: Widerstand
- 486: Widerstand
- 591: Schritt des Bereitstellens
- 593: Schritt des Einlesens
- 595: Schritt des Bereitstellens

## Patentansprüche

1. Vorrichtung (104) zur Stromversorgung für ein Steuergerät (102) für ein Fahrzeug (100), wobei die Vorrichtung (104) die folgenden Merkmale aufweist:
einen ersten Anschluss (110) für einen ersten Stromversorgungspfad, einen zweiten Anschluss (112) für einen zweiten Stromversorgungspfad und einen Sternpunkt (114) zum Verbinden des ersten Stromversorgungspfads und des zweiten Stromversorgungspfads, wobei der Sternpunkt (114) einen Masseanschluss für eine elektrische Schaltung des Steuergeräts (102) repräsentiert;
den ersten Stromversorgungspfad und den zweiten Stromversorgungspfad, wobei die beiden Stromversorgungspfade unabhängige und redundante Masse-Stromversorgungspfade darstellen;
einen ersten Schalter (116) mit einem ersten Kontakt (244) und einem zweiten Kontakt, wobei der erste Kontakt (244) mit dem ersten Anschluss (110) und der zweite Kontakt mit dem Sternpunkt (114) verbunden ist, wobei der ersten Schalter (116) in einem geschlossenen Zustand einen Stromfluss zwischen den Kontakten des ersten Schalters (116) ermöglicht und in einem geöffneten Zustand unterbindet, und einen zweiten Schalter (118) mit einem ersten Kontakt (246) und einem zweiten Kontakt, wobei der erste Kontakt (246) mit dem zweiten Anschluss (112) und der zweite Kontakt mit dem Sternpunkt (114) verbunden ist, wobei der zweite Schalter (118) in einem geschlossenen Zustand einen Stromfluss zwischen den Kontakten des zweiten Schalters (118) ermöglicht und in einem geöffneten Zustand unterbindet;
einen ersten Messkontakt (120) zum Erfassen eines ein Spannungspotenzial des ersten Stromversorgungspfads repräsentierenden ersten Messwertes (264), und einen zweiten Messkontakt (122) zum Erfassen eines ein Spannungspotenzial des zweiten Stromversorgungspfads repräsentierenden zweiten Messwertes (266);
einen dritten Anschluss (258) zum Bereitstellen eines Spannungspotenzials, eine zumindest einen ersten Widerstand (254; 485) und eine erste Diode (380) umfassende erste Stichleitung, die den dritten Anschluss (258) mit dem ersten Anschluss (110) verbindet, und eine zumindest einen zweiten Widerstand (256; 486) und eine zweite Diode (381) umfassende zweite Stichleitung, die den dritten Anschluss (258) mit dem zweiten Anschluss (112) verbindet, wobei der erste Messkontakt (120) auf der ersten Stichleitung und der zweite Messkontakt (122) auf der zweiten Stichleitung angeordnet ist;
eine Steuereinrichtung (124), die ausgebildet ist, um ansprechend auf einen Testzustand der Vorrichtung (104) einen der Schalter (116, 118) geöffnet und den anderen der Schalter (116, 118) geschlossen und während eines voll funktionsfähigen Normalbetriebs den ersten Schalter (116) und den zweiten Schalter (118) geschlossen zu halten; und
eine Überwachungseinrichtung (126), die ausgebildet ist, um unter Verwendung des ersten Messwertes (264) und des zweiten Messwertes (266) ein Überwachungssignal (130) bereitzustellen, wenn sich die Vorrichtung (104) in dem Testzustand befindet.

2. Vorrichtung (104) gemäß Anspruch 1, mit einer Diode (240), die parallel zu dem ersten Schalter (116) zwischen den ersten Anschluss (110) und den Sternpunkt (114) geschaltet ist, und mit einer weiteren Diode (242), die parallel zu dem zweiten Schalter (118) zwischen den zweiten Anschluss (112) und den Sternpunkt (114) geschaltet ist.

3. Vorrichtung (104) gemäß einem der vorangegangenen Ansprüche, bei der die Steuereinrichtung (124) ausgebildet ist, um die Schalter (116, 118) ansprechend auf eine Inbetriebnahme der Vorrichtung (104) zu schließen und/oder bei der die Steuereinrichtung (124) ausgebildet ist, um die Schalter (116, 118) ansprechend auf eine Außerbetriebnahme der Vorrichtung (104) zu öffnen.

4. Vorrichtung (104) gemäß einem der vorangegangenen Ansprüche, bei der die Steuereinrichtung (124) ausgebildet ist, um während einer ersten Phase des Testzustands den ersten Schalter (116) geöffnet und den zweiten Schalter (118) geschlossen zu halten, und während einer zweiten Phase des Testzustands den ersten Schalter (116) geschlossen und den zweiten Schalter (118) geöffnet zu halten.

5. Vorrichtung (104) gemäß einem der vorangegangenen Ansprüche, bei der die Überwachungseinrichtung (126) ausgebildet ist, um den ersten Messwert (264) und den zweiten Messwert (266) miteinander zu vergleichen, um eine Abweichung zwischen den Spannungspotenzialen der Stromversorgungspfade zu ermitteln, wobei das Überwachungssignal (130) die Abweichung anzeigt.

6. Steuergerät (102) für ein Fahrzeug (100), mit einer Vorrichtung (104) gemäß einem der vorangegangenen Ansprüche.

7. Verfahren zur Überwachung einer Stromversorgung für ein Steuergerät (102) gemäß Anspruch 6 für ein Fahrzeug (100), wobei das Verfahren die folgenden Schritte umfasst:
Bereitstellen (591) zumindest eines Steuersignals an eine Schnittstelle zu den Schaltern (116, 118), um ansprechend auf einen Testzustand der Vorrichtung (104) einen der Schalter (116, 118) geöffnet und den anderen der Schalter (116, 118) geschlossen und während eines voll funktionsfähigen Normalbetriebs den ersten Schalter (116) und den zweiten Schalter (118) geschlossen zu halten; und
Einlesen (593) des ersten Messwertes (264) und des zweiten Messwertes (266); und
Bereitstellen (595) eines Überwachungssignals (130) unter Verwendung der Messwerte (264, 266).

## Claims

1. Device (104) for supplying power for a control unit (102) for a vehicle (100), wherein the device (104) has the following features:
a first terminal (110) for a first power supply path, a second terminal (112) for a second power supply path, and a neutral point (114) for connecting the first power supply path and the second power supply path, wherein the neutral point (114) represents a ground terminal for an electric circuit of the control unit (102);
the first power supply path and the second power supply path, wherein the two power supply paths represent independent and redundant ground power supply paths;
a first switch (116) having a first contact (244) and a second contact, wherein the first contact (244) is connected to the first terminal (110) and the second contact is connected to the neutral point (114), wherein the first switch (116) enables current to flow between the contacts of the first switch (116) in a closed state and prevents it in an open state, and a second switch (118) with a first contact (246) and a second contact, wherein the first contact (246) is connected to the second terminal (112) and the second contact is connected to the neutral point (114), wherein the second switch (118) enables current to flow between the contacts of the second switch (118) in a closed state and prevents it in an open state;
a first measuring contact (120) for detecting a first measured value (264) representing a voltage potential of the first power supply path, and a second measuring contact (122) for detecting a second measured value (266) representing a voltage potential of the second power supply path;
a third terminal (258) for providing a voltage potential, a first spur line comprising at least a first resistor (254; 485) and a first diode (380), which connects the third terminal (258) to the first terminal (110), and a second spur line comprising at least a second resistor (256; 486) and a second diode (381), which connects the third terminal (258) to the second terminal (112), wherein the first measuring contact (120) is arranged on the first spur line and the second measuring contact (122) is arranged on the second spur line;
a control device (124) which is configured to keep one of the switches (116, 118) open and the other of the switches (116, 118) closed in response to a test state of the device (104) and to keep the first switch (116) and the second switch (118) closed during a fully functional normal operation; and
a monitoring device (126) which is configured to provide a monitoring signal (130) using the first measured value (264) and the second measured value (266) when the device (104) is in the test state.

2. Device (104) according to claim 1, comprising a diode (240) which is connected in parallel to the first switch (116) between the first terminal (110) and the neutral point (114), and a further diode (242) which is connected in parallel to the second switch (118) between the second terminal (112) and the neutral point (114).

3. Device (104) according to any one of the preceding claims, wherein the control device (124) is configured to close the switches (116, 118) in response to a startup of the device (104) and/or wherein the control device (124) is configured to open the switches (116, 118) in response to a shutdown of the device (104).

4. Device (104) according to any one of the preceding claims, wherein the control device (124) is configured to keep the first switch (116) open and the second switch (118) closed during a first phase of the test state, and to keep the first switch (116) closed and the second switch (118) open during a second phase of the test state.

5. Device (104) according to any one of the preceding claims, wherein the monitoring device (126) is configured to compare the first measured value (264) and the second measured value (266) with each other to determine a deviation between the voltage potentials of the power supply paths, wherein the monitoring signal (130) indicates the deviation.

6. Control unit (102) for a vehicle (100), having a device (104) according to any one of the preceding claims.

7. Method for monitoring a power supply for a control unit (102) according to claim 6 for a vehicle (100), wherein the method comprises the following steps:
providing (591) at least one control signal at an interface to the switches (116, 118) to keep one of the switches (116, 118) open and the other of the switches (116, 118) closed in response to a test state of the device (104) and to keep the first switch (116) and the second switch (118) closed during a fully functional normal operation; and
reading (593) the first measured value (264) and the second measured value (266); and
providing (595) a monitoring signal (130) using the measured values (264, 266).

## Revendications

1. Dispositif (104) destiné à l'alimentation électrique pour un appareil de commande (102) pour un véhicule (100), dans lequel le dispositif (104) présente les caractéristiques suivantes :
une première borne (110) pour un premier chemin d'alimentation électrique, une deuxième borne (112) pour un second chemin d'alimentation électrique et un point neutre (114) destiné à la liaison du premier chemin d'alimentation électrique et du second chemin d'alimentation électrique, dans lequel le point neutre (114) représente une borne de masse pour un circuit électrique de l'appareil de commande (102) ;
le premier chemin d'alimentation électrique et le second chemin d'alimentation électrique, dans lequel les deux chemins d'alimentation électrique représentent des chemins d'alimentation électrique à la masse indépendants et redondants ;
un premier commutateur (116) avec un premier contact (244) et un second contact, dans lequel le premier contact (244) est relié à la première borne (110) et le second contact est relié au point neutre (114), dans lequel le premier commutateur (116) permet dans un état fermé une circulation de courant entre les contacts du premier commutateur (116) et la fait cesser dans un état ouvert et un second commutateur (118) avec un premier contact (246) et un second contact, dans lequel le premier contact (246) est relié à la seconde borne (112) et le second contact est relié au point neutre (114), dans lequel le second commutateur (118) permet dans un état ouvert une circulation de courant entre les contacts du second commutateur (118) et la fait cesser dans un état ouvert ;
un premier contact de mesure (120) destiné à l'acquisition d'une première valeur de mesure (264) représentant un potentiel de tension du premier chemin d'alimentation électrique et un second contact de mesure (122) destiné à l'acquisition d'une seconde valeur de mesure (266) représentant un potentiel de tension du second chemin d'alimentation électrique ;
une troisième borne (258) destinée à la fourniture d'un potentiel de tension, une première ligne en dérivation comprenant au moins une première résistance (254 ; 485) et une première diode (380) qui relie la troisième borne (258) à la première borne (110), et une seconde ligne en dérivation comprenant au moins une deuxième résistance (256 ; 486) et une seconde diode (381) qui relie la troisième borne (258) à la deuxième borne (112), dans lequel le premier contact de mesure (120) est disposé sur la première ligne en dérivation et le second contact de mesure (122) est disposé sur la seconde ligne en dérivation ;
un dispositif de commande (124) qui est configuré pour maintenir ouvert un des commutateurs (116, 118) et maintenir fermé l'autre des commutateurs (116, 118) en réponse à un état de test du dispositif (104) et pour maintenir fermés le premier commutateur (116) et le second commutateur (118) pendant un fonctionnement normal pleinement opérationnel ; et
un équipement de surveillance (126) qui est configuré pour fournir un signal de surveillance (130) en utilisant la première valeur de mesure (264) et la seconde valeur de mesure (266) lorsque le dispositif (104) se trouve dans l'état de test.

2. Dispositif (104) selon la revendication 1, avec une diode (240) qui est montée parallèlement au premier commutateur (116) entre la première borne (110) et le point neutre (114) et avec une diode (242) supplémentaire qui est montée parallèlement au second commutateur (118) entre la première borne (112) et le point neutre (114).

3. Dispositif (104) selon l'une quelconque des revendications précédentes, dans lequel le dispositif de commande (124) est configuré pour fermer les commutateurs (116, 118) en réponse à une mise en service du dispositif (104) et/ou dans lequel l'équipement de commande (124) est configuré pour ouvrir les commutateurs (116, 118) en réponse à une mise hors service du dispositif (104).

4. Dispositif (104) selon l'une quelconque des revendications précédentes, dans lequel le dispositif de commande (124) est configuré pour maintenir ouvert le premier commutateur (116) et maintenir fermé le second commutateur (118) pendant une première phase de l'état de test et maintenir fermé le premier commutateur (116) et maintenir ouvert le second commutateur (118) pendant une seconde phase de l'état de test.

5. Dispositif (104) selon l'une quelconque des revendications précédentes, dans lequel le dispositif de surveillance (126) est configuré pour comparer entre elles la première valeur de mesure (264) et la seconde valeur de mesure (266) pour déterminer un écart entre les potentiels de tension des chemins d'alimentation électrique, dans lequel le signal de surveillance (130) affiche l'écart.

6. Appareil de commande (102) pour un véhicule (100), avec un dispositif (104) selon l'une quelconque des revendications précédentes.

7. Procédé destiné à la surveillance d'une alimentation électrique pour un appareil de commande (102) selon la revendication 6 pour un véhicule (100), dans lequel le procédé comprend les étapes suivantes :
fourniture (591) d'au moins un signal de commande à une interface vers les commutateurs (116, 118), pour maintenir ouvert un des commutateurs (116, 118) en réponse à un état de test du dispositif (104) et maintenir fermé l'autre des commutateurs (116, 118) et maintenir fermés le premier commutateur (116) et le second commutateur (118) pendant un fonctionnement normal pleinement opérationnel ; et
lecture (593) de la première valeur de mesure (264) et de la seconde valeur de mesure (266) ; et
fourniture (595) d'un signal de surveillance (130) en utilisant les valeurs de mesure (264, 266).
